# EUROPEAN PATENT APPLICATION

(11) **EP 4 741 992 A1**
(43) Date of publication of application: **13.05.2026**
(21) Application number: 25212689.1
(22) Date of filing: 31.10.2025
(51) Int. Cl.: G06F 1/16, H04M 1/02

(54) **ELECTRONIC APPARATUS**

(30) Priority: 08.11.2024 KR 20240158449
(71) Applicant: Samsung Display Co., Ltd., Yongin-si, Gyeonggi-do (KR)
(72) Inventor: Kim, Ji-Hoon, Yongin-si, Gyeonggi-Do (KR); Do, Minseok, Yongin-si, Gyeonggi-Do (KR); Park, Youngsang, Yongin-si, Gyeonggi-Do (KR); Byeon, Minseong, Yongin-si, Gyeonggi-Do (KR); An, Sungguk, Yongin-si, Gyeonggi-Do (KR); Lee, Geunwook, Yongin-si, Gyeonggi-Do (KR); Lee, Seungri, Yongin-si, Gyeonggi-Do (KR); Jeong, Chul Ho, Yongin-si, Gyeonggi-Do (KR)
(74) Representative: Gulde & Partner

(57) **Abstract**

Provided is an electronic apparatus including an electronic panel (EP) folded with respect to a folding axis extending along a first direction and including a light-emitting element, and a window member (UPP) on the electronic panel (EP) and folded with respect to the folding axis. The window member (UPP) includes a first film (FL1) on an uppermost side, a second film (FL2) between the first film (FL1) and the electronic panel (EP), a first adhesive layer (AS1) between the first film (FL1) and the second film (FL2) and attached to a rear surface of the first film (FL1), and a second adhesive layer (AS2) between the electronic panel (EP) and the second film (FL2) and attached to the electronic panel (EP). Each of the first film (FL1) and the second film (FL2) has a modulus about 5 GPa or less.

## Description

### BACKGROUND

The present disclosure herein relates to an electronic apparatus, and more particularly, to a foldable electronic apparatus.

A curved or foldable electronic apparatus is currently being developed. Such a flexible electronic apparatus may include an electronic panel, such as a flexible display panel or a flexible touch panel, and a window that covers the electronic panel. The window includes various functional layers. The functional layers may be curved, bent or folded together with the electronic panel.

Layers constituting an electronic apparatus have a relatively flexible property so as to be curved, bent or folded. When the layers have a flexible property, reliability with respect to stress due to bending may be improved, but reliability with respect to external impacts may be reduced.

### SUMMARY

The present disclosure provides a foldable electronic apparatus with improved impact resistance and flexibility.

An embodiment of the present disclosure provides an electronic apparatus including an electronic panel being foldable (e.g., being folded) with respect to a folding axis extending along a first direction and including a light-emitting element, and a window member on the electronic panel and being foldable (e.g., being folded) with respect to the folding axis. The window member includes a first film on an uppermost side, a second film between the first film and the electronic panel, a first adhesive layer between the first film and the second film and attached to a rear surface of the first film, and a second adhesive layer between the electronic panel and the second film and attached to the electronic panel. One or more (e.g., each) of the first film and the second film has a modulus of about 5 GPa or less, and, preferably, a modulus of the second film is greater than about 700 MPa.

In an embodiment, the modulus of the second film may be smaller than the modulus of the first film. This further enhances the repulsive force and impact resistance of the window by addressing the position related load to the films.

In an embodiment, one or more (e.g., each) of the first film and the second film may have a thickness in a range from approximately 20 µm (e.g., 40 µm) to approximately 100 µm (e.g., 80 µm). This further enhances the repulsive force and impact resistance of the window by addressing the thickness related load to the films.

In an embodiment, the electronic apparatus may further include a third film. between the electronic panel and the second film (and/or on a lowermost side of the window member), and a third adhesive layer between the third film and the second film and bonding the second film and the third film. This enhances the repulsive force and impact resistance of the window by increasing the overall thickness.

In an embodiment, a modulus of the third film may be about 5 GPa or less and/or 700 MPa or more (e.g., 100 GPa or more). This further enhances the repulsive force and impact resistance of the window by addressing the load to the films.

In an embodiment, the modulus of the second film may be smaller than the modulus of one or more (e.g., each) of the first film and the third film. This further enhances the repulsive force and impact resistance of the window by addressing the position related load to the films.

In an embodiment, the first to third films may each have a thickness of greater than about 20 µm (e.g., 40 µm) and/or smaller than about 100 µm (e.g., 80 µm). This further enhances the repulsive force and impact resistance of the window by addressing the thickness related load to the films.

In an embodiment, a thickness of the third film may be greater than or equal to a thickness of one or more (e.g., each) of the first film and the second film. This further enhances the repulsive force and impact resistance of the window by addressing the thickness related load to the films.

In an embodiment, the thickness of the second film may be less than or equal to the thickness of one or more (e.g., each) of the first film and the third film. This further enhances the repulsive force and impact resistance of the window by addressing the thickness related load to the films.

In an embodiment, the electronic apparatus may further include a fourth film between the third film and the second film, wherein a modulus of the fourth film is about 5 GPa or less and/or 700 MPa or more (e.g., 100 GPa or more). This enhances the repulsive force and impact resistance of the window by increasing the overall thickness.

In an embodiment, one or more (e.g., each) of the first film and the second film may have a light transmittance of about 90% or more. This enhances transparency of the window.

In an embodiment, one or more (e.g., each) of the first film and the second film may include a resin or may be made from the resin. Resin further enhances the repulsive force and impact resistance of the window over time as being a time durable and environment stable material.

In an embodiment, the electronic panel may include a color filter or black matrix. This enhances usability.

In an embodiment, the window member may be being foldable (e.g., being folded) in a direction surrounding the folding axis. This enhances usability.

An embodiment of the present disclosure provides the electronic apparatus including an electronic panel being foldable (e.g., being folded) with respect to a folding axis extending along a first direction and including a light-emitting element, a window member on the electronic panel and being foldable (e.g., being folded) with respect to the folding axis, and a housing under the electronic panel and configured to provide an accommodation space for accommodating the electronic panel. The window member includes a first film on an uppermost side, a second film between the first film and the electronic panel, a third film on a lowermost side and bonded to the electronic panel via an adhesive layer. One or more (e.g., each) of the first to third films has a modulus of about 5 GPa or less, and, preferably, the second film has a modulus of about 700 MPa or more.

In an embodiment, the modulus of the second film may be smaller than the modulus of one or more (e.g., each) of the first film and the third film. This further enhances the repulsive force and impact resistance of the window by addressing the position related load to the films.

In an embodiment, the modulus of the third film may be greater than or equal to the modulus of the first film. This further enhances the repulsive force and impact resistance of the window by addressing the position related load to the films.

In an embodiment, the first to third films may each have a thickness of greater than about 20 µm (e.g., 40 µm) and smaller than about 100 µm (e.g., 80 µm). This further enhances the repulsive force and impact resistance of the window by addressing the thickness related load to the films.

In an embodiment, the thickness of the first film may be greater than or equal to the thickness of one or more (e.g., each) of the second film and the third film. This further enhances the repulsive force and impact resistance of the window by addressing the thickness related load to the films.

In an embodiment, the electronic panel may further include a color filter or black matrix. This enhances usability.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIGS. 1A and 1B are perspective views of an electronic apparatus according to an embodiment of the present disclosure;
FIGS. 2A and 2B are perspective views of an electronic apparatus according to an embodiment of the present disclosure;
FIG. 3A is an exploded perspective view of an electronic apparatus according to an embodiment of the present disclosure;
FIG. 3B is a block diagram of an electronic apparatus according to an embodiment of the present disclosure;
FIG. 3C is a cross-sectional view of an electronic panel according to an embodiment of the present disclosure;
FIGS. 4A and 4B are cross-sectional views schematically illustrating an electronic apparatus according to an embodiment of the present disclosure;
FIGS. 5A to 5C are cross-sectional views schematically illustrating an electronic apparatus according to an embodiment of the present disclosure;
FIG. 6 is a diagram illustrating an electronic apparatus according to an embodiment of the present disclosure;
FIGS. 7 to 11 are diagrams illustrating an electronic apparatus according to an embodiment of the present disclosure.

### DETAILED DESCRIPTION

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, the thickness, ratio, and size of the elements are exaggerated for effectively describing the technical contents. As used herein, the term "and/or" includes any and all combinations of one or more of the associated listed elements.

It will be understood that, although the terms "first", "second", etc. may be used herein to describe various elements, the elements are not to be limited by these terms. These terms are only used to distinguish one element from another element. For instance, a first element could be termed a second element without departing from the scope of the present disclosure. Similarly, a second element could be termed a first element. In this specification, the singular expressions "a", "an" and "the" are intended to include the plural forms as well, unless the context clearly indicates otherwise.

In addition, the terms "below", "under", "on the lower side", "above", "over", "on the upper side", or the like may be used to describe the relationships between the elements illustrated in the drawings. These terms are relative concepts and are described on the basis of the directions indicated in the drawings.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

Hereinafter, embodiments of the present disclosure are described with reference to the drawings.

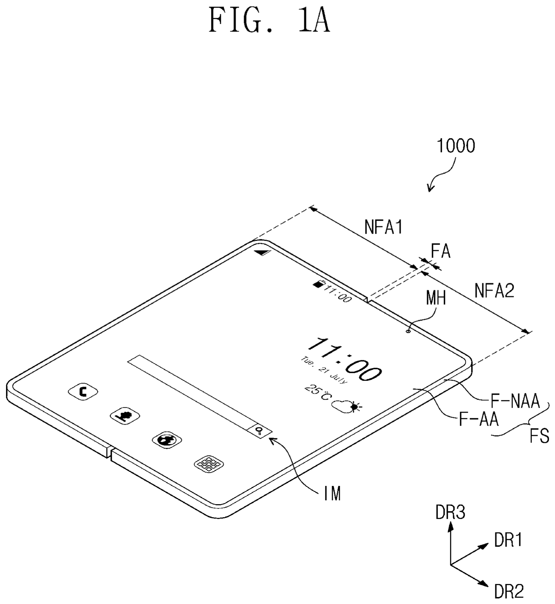

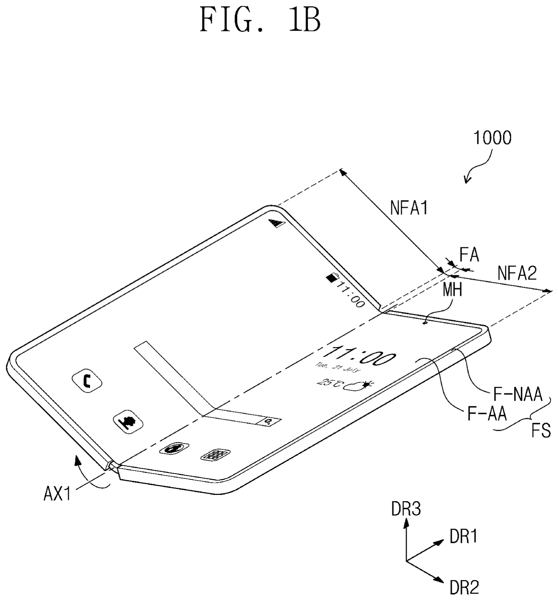

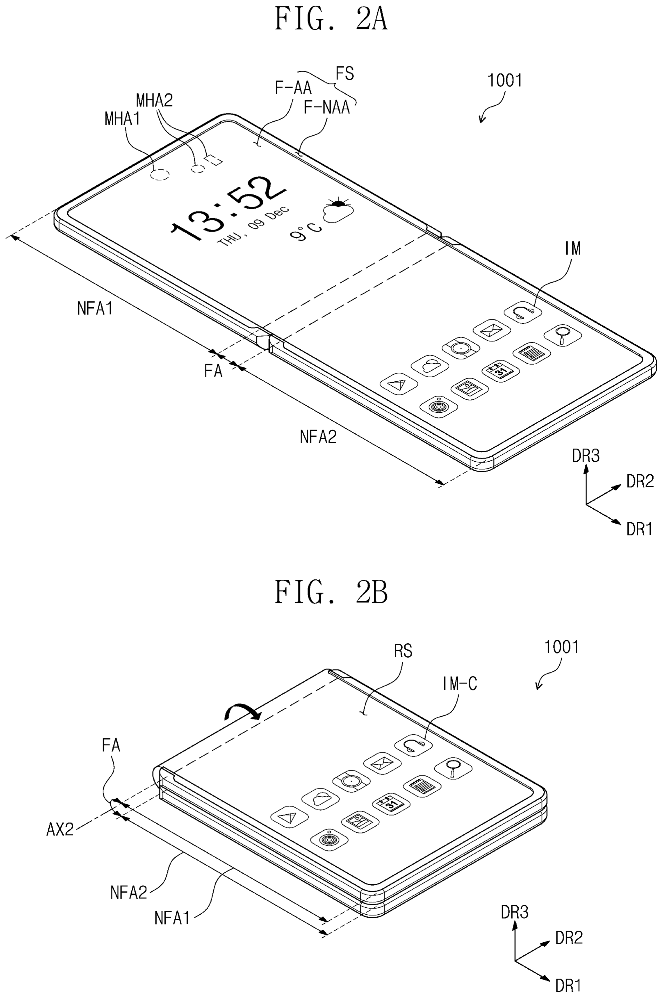

FIGS. 1A and 1B are perspective views of an electronic apparatus according to an embodiment of the present disclosure. FIGS. 2A and 2B are perspective views of an electronic apparatus according to an embodiment of the present disclosure. FIG. 1A is a perspective view of an electronic apparatus 1000 in an unfolded state, and FIG. 1B is a perspective view of the electronic apparatus 1000 illustrated in FIG. 1A in a folded state. FIG. 2A is a perspective view of an electronic apparatus 1001 in an unfolded state, and FIG. 2B is a perspective view of the electronic apparatus 1001 illustrated in FIG. 2A in a folded state. Hereinafter, the present disclosure will be described with reference to FIGS. 1A to 2B.

The electronic apparatuses 1000 and 1001 may be activated in response to electrical signals. The electronic apparatuses 1000 and 1001 may include various embodiments. For example, the electronic apparatuses 1000 and 1001 may include a tablet computer, a laptop, a computer, a smart television, and the like. In an embodiment of the present disclosure, the electronic apparatuses 1000 and 1001 are illustrated as a smartphone as an example.

The electronic apparatuses 1000 and 1001 may display an image IM in a third direction DR3 on a first display surface FS parallel to each of a first direction DR1 and a second direction DR2. The first display surface FS on which the image IM is displayed may correspond to a front surface of each of the electronic apparatuses 1000 and 1001. The image IM may include a dynamic image as well as a still image. In FIGS. 1A to 2B, an Internet search window and a clock window are illustrated as an example of the image IM.

In some embodiments, in an unfolded state, a front surface (or an upper surface) and a rear surface (or a lower surface) of each of components are defined based on the direction in which the image IM is displayed. The front surface and the rear surface are opposite to each other in the third direction DR3, and a normal direction of each of the front surface and the rear surface may be parallel to the third direction.

A separation distance between the front surface and the rear surface in the third direction DR3 may correspond to a thickness/height of each of the electronic apparatuses 1000 and 1001 in the third direction DR3. In some embodiments, the directions indicated by the first to third directions DR1 to DR3 are relative concepts and may thus be changed into other directions.

The electronic apparatuses 1000 and 1001 may detect an external input applied from the outside. The external input may be an input of a user. The input of a user may include various types of inputs such as a portion of a body of a user, an electromagnetic pen, light, heat, or pressure.

For example, the external input may include not only a touch by a portion of a body of a user, such as a user's hand, but also an external input (for example, hovering) applied while being in proximity to the electronic apparatuses 1000 and 1001 or being close to the electronic apparatuses 1000 and 1001 by a set or predetermined distance. The external input may include various types such as force, pressure, temperature, and light. In some embodiments, the electronic apparatuses 1000 and 1001 according to the present disclosure may detect an external input applied by an electromagnetic pen that generates a magnetic field. In some embodiments, the electronic apparatuses 1000 and 1001 may detect a plurality of inputs having different types. For example, the electronic apparatuses 1000 and 1001 may detect an external input applied by a pen and an external input applied by a user's hand. Although not illustrated, the electromagnetic pen may be attached to or detached from the inside or outside of the electronic apparatuses 1000 and 1001, and the electronic apparatuses 1000 and 1001 may provide and receive a signal corresponding to the attachment and detachment of the electromagnetic pen.

Referring to FIGS. 1A and 1B, the display surface FS may include a first active region (active region) F-AA and a first peripheral region (peripheral region) F-NAA. The peripheral region F-NAA is adjacent to the active region F-AA. In some embodiments, the peripheral region F-NAA has a lower light transmittance than the active region F-AA, and may have a set or predetermined color.

In some embodiments, a set or predetermined electronic module region MH may be defined in the display surface FA. It is illustrated that the electronic module region MH is provided in the active region F-AA, but is not limited thereto and may also be provided in the peripheral region F-NAA. The electronic module region MH may be a region in which at least one of electronic modules to be described later is disposed. For example, the electronic apparatus 1000 may image-capture or detect an external subject through the electronic module region MH.

In some embodiments, the peripheral region F-NAA may surround the active region F-AA. Accordingly, the shape of the active region F-AA may be substantially defined by the peripheral region F-NAA. However, this is merely an example, and the peripheral region F-NAA may be disposed adjacent to only one side of the active region F-AA, or may be omitted.

The electronic apparatus 1000 according to an embodiment of the present disclosure may be folded with respect to a set or predetermined folding axis. For example, referring to FIG. 1B, a virtual first folding axis AX1 extending in the first direction DR1 may be defined in the electronic apparatus 1000. The first folding axis AX1 may extend along the first direction DR1 on the display surface FS.

The display surface FS of the electronic apparatus 1000 may include a folding region FA folded with respect to the first folding axis AX1, and a first non-folding region NFA1 and a second non-folding region NFA2 which are spaced apart from each other in the second direction DR2 with the folding region FA therebetween. The electronic apparatus 1000 may be folded with respect to the first folding axis AX1 and in-folded such that the first non-folding region NFA1 and the second non-folding region NFA2 are folded in a direction facing each other.

In some embodiments, although not illustrated, the electronic apparatus 1000 may be folded by a plurality of folding axes spaced apart along the first direction DR1. The electronic apparatus 1000 according to an embodiment of the present disclosure may include various embodiments as long as being capable of displaying the image IM and being foldable, and is not limited to any one embodiment.

Referring to FIGS. 2A and 2B, the electronic apparatus 1001 may have a shape different from the shape of the electronic apparatus 1000 illustrated in FIGS. 1A and 1B. Specifically, the electronic apparatus 1001 may have a rectangular shape having long sides extending in the first direction DR1 and short sides extending in the second direction DR2. However, the present disclosure is not limited thereto, and the electronic apparatus 1001 may have various shapes such as a circle and a polygon. A display surface FS may include a second active region (active region) F-AA and a second peripheral region (peripheral region) F-NAA. The peripheral region F-NAA is adjacent to the active region F-AA. The peripheral region F-NAA has a lower light transmittance than the active region F-AA, and may have a set or predetermined color.

In some embodiments, a plurality of electronic module regions MHA1 and MHA2 may be defined on the display surface FA. Although it is illustrated that the electronic module regions MHA1 and MHA2 are provided in the active region F-AA, the electronic module regions MHA1 and MHA2 are not limited thereto and may also be provided in the peripheral region F-NAA. Each of the electronic module regions MHA1 and MHA2 may be a region in which at least one of electronic modules to be described later is disposed. For example, the electronic apparatus 1001 may image-capture an external subject through one of the electronic module regions MHA1 and MHA2, and may detect the external subject through the other one of the electronic module regions MHA1 and MHA2.

In some embodiments, the peripheral region F-NAA may surround the active region F-AA. Accordingly, the shape of the active region F-AA may be substantially defined by the peripheral region F-NAA. However, this is illustrated as an example, and the peripheral region F-NAA may be disposed adjacent to only one side of the active region F-AA or may be omitted.

The electronic apparatus 1001 according to an embodiment of the present disclosure may be a foldable display. Therefore, the electronic apparatus 1001 may be folded with respect to a set or predetermined folding axis. Unlike the electronic apparatus 1000 illustrated in FIG. 1A, the electronic apparatus 1001 may be folded with respect to a folding axis AX2 extending along the second direction DR2. Accordingly, the first non-folding region NFA1, the folding region FA, and the second non-folding region NFA2 may be arranged along the first direction DR1.

Referring to FIG. 2B, the electronic apparatus 1001 may further include an outer display surface RS which is viewed from the outside in a folded state. Although not illustrated, in a state in which the electronic apparatus 1001 is unfolded as in FIG. 2A, the outer display surface RS may be disposed on a bottom surface side opposed to the display surface FS in the third direction DR3. The electronic apparatus 1001 may provide the image IM to a user through the display surface FS in the unfolded state and may provide an image IM-C to the user through the outer display surface RS in the folded state. The user may easily view information provided by the electronic apparatus 1001 even in a folded state through the electronic apparatus 1001. According to the present disclosure, the electronic apparatus 1001 may be any one as long as serving as a foldable display, and the position of the folding axis AX2 may be changed variously. The present disclosure is not limited to any one embodiment.

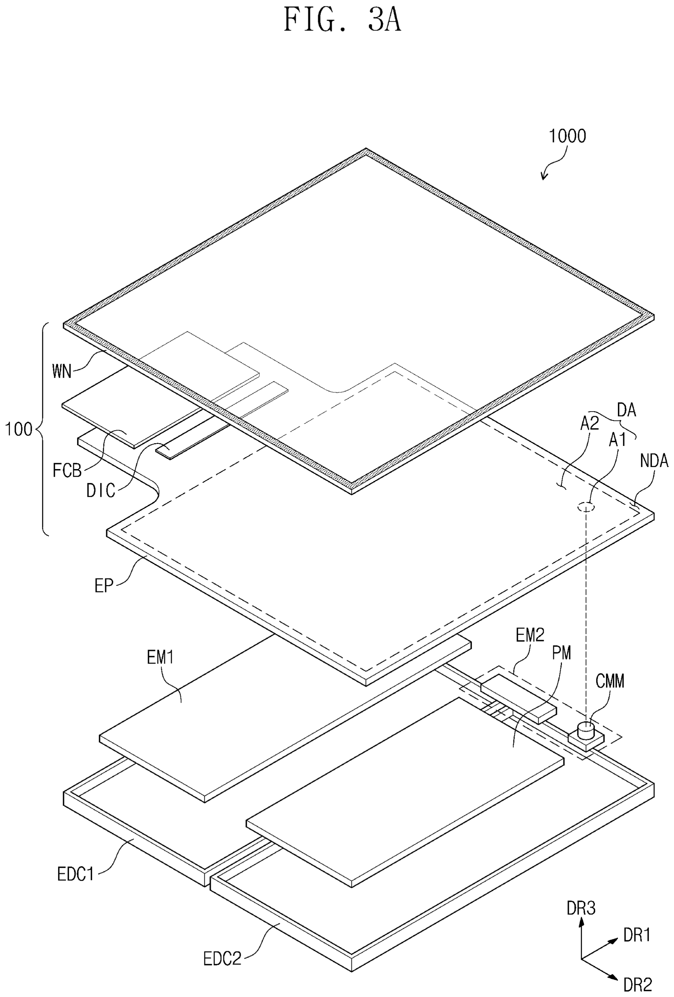

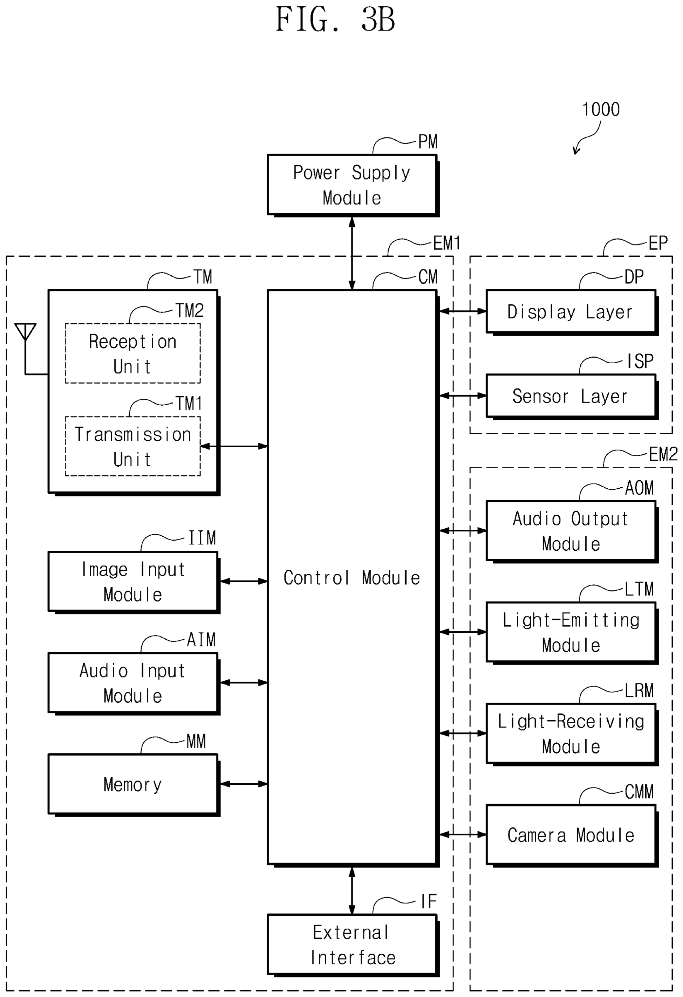

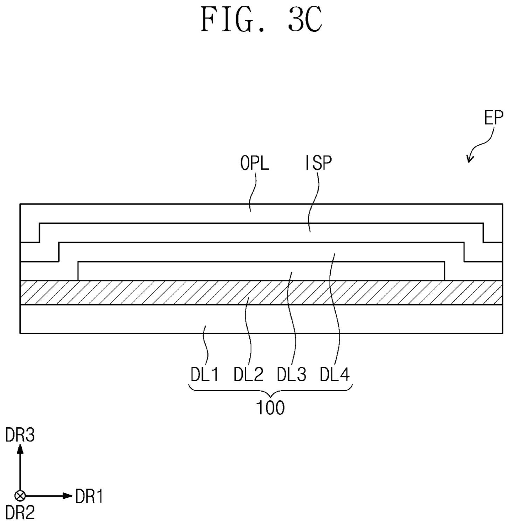

FIG. 3A is an exploded perspective view of an electronic apparatus according to an embodiment of the present disclosure. FIG. 3B is a block diagram of an electronic apparatus according to an embodiment of the present disclosure. FIG. 3C is a cross-sectional view schematically illustrating an electronic panel according to an embodiment of the present disclosure. Although FIGS. 3A and 3B illustrate the electronic apparatus 1000 illustrated in FIG. 1A, this is illustrated as an example, and the following description may also be similarly applied to the electronic apparatus 1001 illustrated in FIG. 2A or an electronic apparatus of another geometry. Hereinafter, the present disclosure will be described with reference to FIGS. 3A to 3C.

Referring to FIGS. 3A and 3B, the electronic apparatus 1000 may include a display device 100, a first electronic module EM1, a second electronic module EM2, a power supply module PM, and housings EDC1 and EDC2. The electronic apparatus 1000 may further include a mechanical structure for controlling a folding operation of the display device 100.

In some embodiments, the display device 100 includes a window member WN and an electronic panel EP. The window member WN may cover an upper surface of the electronic panel EP and provide a front surface of the electronic apparatus 1000.

Although FIG. 3A illustrates only the electronic panel EP and the window member WN as components of the display device 100, the display device 100 may substantially be a stacked structure in which a plurality of components including the electronic panel EP are stacked. For example, the display device 100 may further include at least one component, such as a support plate or an impact absorbing layer disposed on a rear surface of the electronic panel EP.

The electronic panel EP includes a display region DA and a non-display region NDA. The display region DA may correspond to the active region F-AA described above (see FIG. 1A), and the non-display region NDA may correspond to the peripheral region F-NAA (see FIG. 1A). In this specification, the wording, "a region/part corresponds to a region/part" means that they overlap, and is not limited to the same area.

The display region DA may include a first region A1 and a second region A2. The first region A1 may overlap or may correspond to the electronic module region MH (see FIG. 1A) of the electronic apparatus 1000. In some embodiments, although illustrated in a circular shape, the first region A1 may have various shapes such as a polygon, an ellipse, a figure having at least one curved side, or an atypical shape, and is not limited to any one embodiment. The first region A1 may be referred to as a "component region", and the second region A2 may be referred to as a "main display region or a general display region".

The first region A1 may have a higher transmittance than the second region A2. In some embodiments, the resolution of the first region A1 may be lower than the resolution of the second region A2, but is not limited thereto. For example, the first region A1 may have a higher transmittance than the second region A2, but the resolution of the first region A1 may be substantially the same as the resolution of the second region A2. The first region A1 may overlap a camera module CMM. In an embodiment of the present disclosure, a portion of the electronic panel EP corresponding to the first region A1 may be removed. Therefore, an image may not be displayed in the first region A1.

Referring to FIG. 3C, the electronic panel EP may include a display layer DP, a sensor layer ISP, and an optical layer OPL. The display layer DP may be a component that substantially generates an image. The display layer DP may be a light-emitting display layer and may be, for example, an organic light-emitting display layer, an inorganic light-emitting display layer, an organic-inorganic light-emitting display layer, a quantum dot display layer, a micro LED display layer, or a nano LED display layer. The display layer DP may include a base layer DL1, a circuit layer DL2, an element layer DL3, and an encapsulation layer DL4.

The base layer DL1 may be a member providing a base surface on which the circuit layer DL2 is disposed or arranged. The base layer DL1 may be a glass substrate, a metal substrate, a silicon substrate, a polymer substrate, or the like. However, embodiments are not limited thereto, and the base layer DL1 may be an inorganic layer, an organic layer, or a composite material layer.

The circuit layer DL2 may be disposed or arranged on the base layer DL1. The circuit layer DL2 may include an insulating layer, a semiconductor pattern, a conductive pattern, a signal line, and the like. The insulating layer, the semiconductor layer, and the conductive layer are formed on the base layer DL1 through coating, deposition, or the like, and thereafter, the insulating layer, the semiconductor layer, and the conductive layer may be selectively patterned by performing a photolithography process multiple times. Thereafter, the semiconductor pattern, the conductive pattern, and the signal line included in the circuit layer DL2 may be formed.

The element layer DL3 may be disposed or arranged on the circuit layer DL2. The element layer DL3 may include a light-emitting element. For example, the element layer DL3 may include an organic light-emitting material, an inorganic light-emitting material, an organic-inorganic light-emitting material, a quantum dot, a quantum rod, a micro LED, or a nano LED.

The encapsulation layer DL4 may be disposed or arranged on the element layer DL3. The encapsulation layer DL4 may protect the element layer DL3 from foreign substances such as moisture, oxygen, and dust particles.

The sensor layer ISP may be disposed or arranged on the display layer DP. The sensor layer ISP may detect an external input applied from the outside. The external input may be an input of a user. The input of a user may include various types of external inputs such as a portion of a body of a user, light, heat, a pen, or pressure.

The sensor layer ISP may be formed on the display layer DP through a continuous process. In this case, it may be expressed that the sensor layer ISP is directly disposed or arranged on the display layer DP. The wording, "directly disposed or arranged" may mean that a third element is not disposed or arranged between the sensor layer ISP and the display layer DP. That is, a separate adhesive member may not be disposed or arranged between the sensor layer ISP and the display layer DP. In some embodiments, the sensor layer ISP may be bonded to the display layer DP through an adhesive member. The adhesive member may include a typical adhesive or bonding agent.

The optical layer OPL may be disposed or arranged on the sensor layer ISP. The optical layer OPL may reduce a reflectance for external light incident from the outside of the electronic apparatus 1000. The optical layer OPL may be directly disposed or arranged on the sensor layer ISP. However, the present disclosure is not limited thereto, and an adhesive member may be disposed or arranged between the optical layer OPL and the sensor layer ISP.

Referring again to FIGS. 3A and 3B, a driving unit DIC and a circuit board FCB may include driving elements for driving pixels of the display layer DP. The driving unit DIC may include, for example, a gate driving circuit or a data driving circuit, and the circuit board FCB may include, for example, a timing control circuit or a power supply circuit. In some embodiments, the driving unit DIC and the circuit board FCB may include driving elements for driving the sensor layer ISP. However, this is merely illustrated as an example, and the driving elements for driving the sensor layer ISP may be provided on a substrate separate from the driving unit DIC or the circuit board FCB. The present disclosure is not limited to any one embodiment.

The driving unit DIC may be disposed or arranged in the non-display region NDA. However, this is illustrated as an example, and the driving unit DIC may be disposed or arranged in the display region DA, and the arrangement position of the driving unit DIC is not limited to any one embodiment. Although FIG. 3A illustrates a structure in which the driving unit DIC is mounted in a chip form on the electronic panel EP, the present disclosure is not limited thereto. For example, the driving unit DIC may be mounted on the circuit board FCB and connected to the electronic panel EP through the circuit board FCB.

The power supply module PM supplies power required for overall operations of the electronic apparatus 1000. The power supply module PM may include a typical battery module. Although not illustrated, the circuit board FCB may be connected to the power supply module PM to receive power, and the power required for the electronic panel EP or the driving unit DIC may be supplied through the circuit board FCB.

The first electronic module EM1 and the second electronic module EM2 include various functional modules for operating the electronic apparatus 1000. Each of the first electronic module EM1 and the second electronic module EM2 may be mounted directly on a mother board electrically connected to the electronic panel EP or may be mounted on a separate board to be electrically connected to the mother board through a connector (not illustrated) or the like. The mother board may be provided separately or may correspond to the circuit board FCB.

The first electronic module EM1 may include a control module CM, a wireless communication module TM, an image input module IIM, an audio input module AIM, a memory MM, and an external interface IF.

The control module CM controls overall operations of the electronic apparatus 1000. The control module CM may be a microprocessor. For example, the control module CM activates or deactivates the electronic panel EP. The control module CM may control other modules, such as the image input module IIM and the audio input module AIM, on the basis of a touch signal received from the electronic panel EP.

The wireless communication module TM may communicate with an external electronic apparatus through a first network (for example, a short-range communication network such as Bluetooth, WiFi direct, or infrared data association (IrDA)) or a second network (for example, a long-range communication network such as a cellular network, an Internet, or a computer network (for example, a LAN or a WAN)). The communication modules included in the wireless communication module TM may be integrated into a single component (for example, a single chip), or may be implemented as a plurality of components (for example, a plurality of chips) separated from each other. The wireless communication module TM may transmit/receive a voice signal by using a general communication line. The wireless communication module TM may include a transmission unit TM1 which modulates and transmits a signal to be transmitted, and a reception unit TM2 which demodulates a received signal.

The image input module IIM processes an image signal and converts the image signal into image data which may be displayed on the electronic panel EP. The audio input module AIM receives an external audio signal through a microphone in a recording mode, a voice recognition mode, and the like and converts the received audio signal into electrical voice data.

The external interface IF may include a connector capable of physically connecting the electronic apparatus 1000 to an external electronic apparatus. For example, the external interface IF serves as an interface connected to an external charger, a wired/wireless data port, a card (for example, a memory card, a SIM/UIM card) socket, and the like.

The second electronic module EM2 may include an audio output module AOM, a light-emitting module LTM, a light-receiving module LRM, the camera module CMM, and the like. The audio output module AOM converts audio data received from the wireless communication module TM or audio data stored in the memory MM, and outputs the converted audio data to the outside.

The light-emitting module LTM generates and outputs light. The light-emitting module LTM may output infrared rays. The light-emitting module LTM may include an LED element. The light-receiving module LRM may detect the infrared rays. The light-receiving module LRM may be activated when the infrared rays higher than a set or predetermined level are detected. The light-receiving module LRM may include a CMOS sensor. After infrared light generated by the light-emitting module LTM is output, the infrared light may be reflected by an external object (for example, a user's finger or face), and the reflected infrared light may be incident on the light-receiving module LRM.

The camera module CMM may capture a still image and a moving image. In some embodiments, the electronic apparatus 1000 may include more than one camera module CMM. A portion of the camera modules CMM may overlap the first region A1. An external input (for example, light) may be provided to the camera module CMM through the first region A1. For example, the camera module CMM may capture an external image by receiving natural light through the first region A1.

The housings EDC1 and EDC2 may provide an accommodation space. The electronic panel EP, the first and second electronic modules EM1 and EM2, and the power supply module PM may be accommodated in the accommodation space. The housings EDC1 and EDC2 protect components accommodated in the accommodation space. In FIG. 3A, two housings EDC1 and EDC2 separated from each other are illustrated as an example, but the present disclosure is not limited thereto. Although not illustrated, the electronic apparatus 1000 may further include a hinge structure for connecting the two housings EDC1 and EDC2. The housings EDC1 and EDC2 may be coupled to the window member UPP. The electronic apparatus 1000 according to an embodiment of the present disclosure may include various other components, and may be provided while any components illustrated may be omitted, and is not limited to any one embodiment.

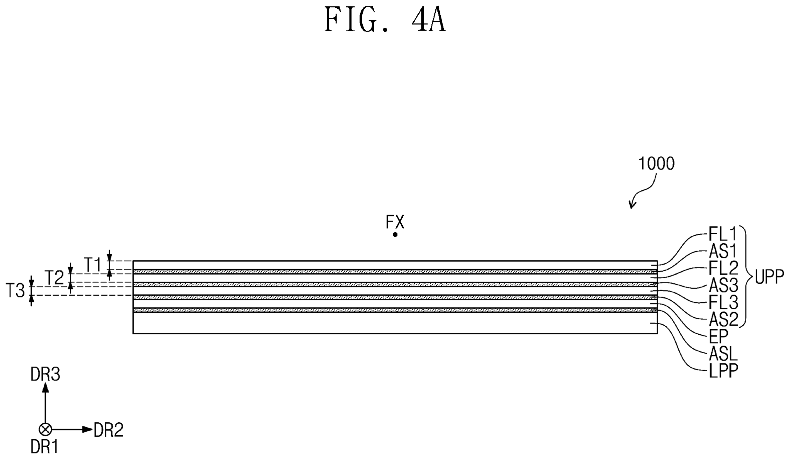

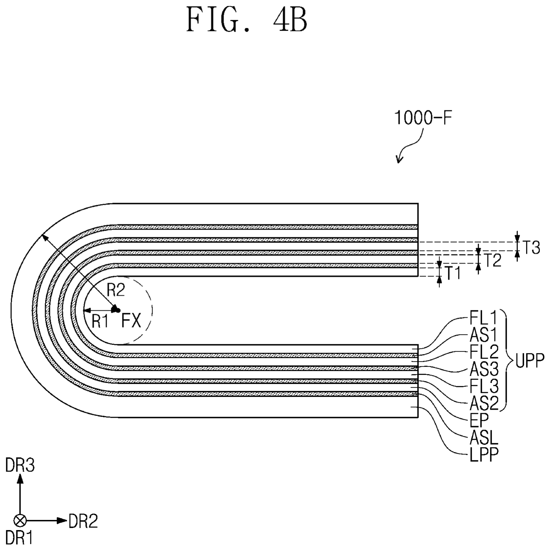

FIGS. 4A and 4B are cross-sectional views schematically illustrating an electronic apparatus according to an embodiment of the present disclosure. FIG. 4A is a cross-sectional view of the electronic apparatus in a state illustrated in FIG. 1A, and FIG. 4B is a cross-sectional view of the electronic apparatus in a folded state. Hereinafter, the present disclosure will be described with reference to FIGS. 4A and 4B.

The electronic apparatus 1000 or 1000-F may include a window member UPP, an electronic panel EP, and a lower member LPP. The lower member LPP may be bonded to a rear surface of the electronic panel EP through an adhesive layer ASL.

In some embodiments, the electronic panel EP has a flexible property. Accordingly, the electronic panel EP may be folded or unfolded with respect to the folding axis FX. The electronic panel EP may include a display panel which displays an image, a sensing panel which detects an external input, or a combination thereof. In some embodiments, the electronic panel EP includes a display panel. Accordingly, the electronic panel EP displays the image IM (see FIG. 1A). The display panel may be any one among a liquid crystal display panel, an organic light-emitting display panel, an electrophoretic display panel, and an electric wet display panel. The electronic panel EP may include a plurality of pixels. Each of the pixels may generate light for forming the image IM.

In some embodiments, the window member UPP is disposed or arranged on the electronic panel EP. An upper surface of the window member UPP defines a front surface FS (see FIG. 1A) of the electronic apparatus 1000. The window member UPP may be disposed or arranged on a display surface of the electronic panel EP. The window member UPP may be optically transparent. Accordingly, the image IM generated from the electronic panel EP may penetrate the window member UPP and may be recognized by the user.

In some embodiments, the window member UPP has a flexible property. Accordingly, the window member UPP may be folded or unfolded with respect to the folding axis FX. The window member UPP may include multiple films, e.g., first to third films FL1, FL2, and FL3, and multiple (e.g., a plurality of) adhesive layers AS1, AS2, and AS3. One or more (e.g., each) of the adhesive layers AS1, AS2, AS3, and ASL according to the present embodiment may include a pressure-sensitive adhesive layer PSA. For a facilitated understanding, reference is made to the first to third films FL1, FL2, and FL3, wherein it may be understood that the references made hereto apply in analogy to more to less the three films.

One or more (e.g., each) of the first to third films FL1, FL2, and FL3 may include an organic material, and may be a substantially transparent film having a light transmittance of 90% or more. For example, each of the first to third films FL1, FL2, and FL3 may include a resin such as polyimide (PI), e.g., being made therefrom. The first to third films FL1, FL2, and FL3 may be composed of the same material or different materials.

The first film FL1 may be disposed or arranged on an uppermost side of the window member UPP to define the upper surface of the window member UPP. The first film FL1 may be a film which is spaced farthest from the electronic panel EP among the films constituting the window member UPP. The first film FL1 may protect an upper surface of the electronic apparatus 1000. The first film FL1 may have a modulus (tensile modulus, e.g., Young's modulus) of about 5 GPa or less at room temperature (25 °C). A thickness T1 of the first film FL1 may be about 20 µm to about 100 µm.

The second film FL2 may be disposed or arranged under the first film FL1. The second film FL2 may be a film bonded to the first film FL1 through a set or predetermined adhesive layer (hereinafter, referred to as the "first adhesive layer") AS1 among the films constituting the window member UPP. The second film FL2 may serve to protect the electronic panel EP. The second film FL2 may have a modulus of about 5 GPa or less at room temperature. The modulus of the second film FL2 may be less than or equal to the modulus of the first film FL1. A thickness T2 of the second film FL2 may be about 20 µm to about 100 µm.

The third film FL3 may be disposed or arranged under the second film FL2. The third film FL3 may be a film disposed or arranged on a lowermost side among the films constituting the window member UPP and coupled to the electronic panel EP. The third film FL3 may be attached to an upper surface of the electronic panel EP through the second adhesive layer AS2 (hereinafter, referred to as a "second adhesive layer"). In some embodiments, the third film FL3 and the second film FL2 may be bonded to each other through the third adhesive layer AS3. The third film FL3 may be an impact-resistant film or an optical film such as an anti-reflection film, but is not limited thereto. The third film FL3 may have a modulus of about 5 GPa or less at room temperature. The modulus of the third film FL3 may be greater than or equal to the modulus of the second film FL2. A thickness T3 of the third film FL3 may be about 20 µm to about 100 µm.

In some embodiments, the room-temperature modulus of one or more (e.g., each) of the films constituting the window member UPP may be about 5 GPa or less. That is, the window member UPP may include only the first to third films FL1, FL2, and FL3 having a modulus of about 5 GPa or less and the adhesive layers AS1, AS2, and AS3 which bond the first to third films FL1, FL2, and FL3. The room-temperature modulus of one or more (e.g., each) of the adhesive layers AS1, AS2, AS3, and ASL according to some embodiments may be about 1 MPa or less. Since the window member UPP does not include a film having an excessively large modulus, a repulsive force against folding stress may be reduced. Accordingly, bending properties of the electronic apparatus 1000 may be improved, and the electronic apparatus 1000 may be easily folded.

In some embodiments, the uppermost film and the lowermost film among the films constituting the window member UPP may be designed to have a relatively high modulus. In some embodiments, in the window member UPP, the modulus of the first film FL1 and the modulus of the third film FL3 may be greater than or equal to the modulus of the second film FL2. The room-temperature modulus of the second film FL2 may be about 700 MPa to about 5 GPa (e.g., to about 4 GPa or less, e.g., to about 3 GPa or less, e.g., to about 2 GPa).

The lower member LPP may be disposed or arranged on the rear surface of the electronic panel EP. The lower member LPP may have a higher modulus or higher elasticity than the electronic panel EP. The lower member LPP may help reduce an external impact applied from the lower side of the electronic apparatus 1000 from being transferred to the electronic panel EP, to help improve the reliability of the electronic apparatus 1000.

The adhesive layer ASL may be disposed or arranged between the electronic panel EP and the lower member LPP to bond the electronic panel EP and the lower member LPP. In some embodiments, the adhesive layer ASL may be omitted. In this case, the lower member LPP may be formed directly on the rear surface of the electronic panel EP to adhere to the electronic panel EP, and is not limited to any one embodiment.

The folded electronic apparatus 1000-F may be folded in a manner surrounding the folding axis FX. One or more (e.g., each) of components constituting the electronic apparatus 1000 may be folded with respect to the folding axis FX. The window member WN most adjacent to the folding axis FX may be folded with a first radius of curvature R1. The first radius of curvature R1 may be defined as a distance from the front surface of the window member WN to the folding axis FX.

The electronic panel EP spaced farthest from the folding axis FX may be folded with a second radius of curvature R2. The second radius of curvature R2 may be defined as a distance from the rear surface of the electronic panel EP to the folding axis FX.

In some embodiments, the folding axis FX is defined on the front surface of the window member WN. Accordingly, the second radius of curvature R2 has a value larger than the first radius of curvature R1. The first radius of curvature R1 and the second radius of curvature R2 may each be about 2 mm or less. The electronic apparatus 1000 according to the present disclosure may be stably folded even under a fine radius of curvature.

Hereinafter, the window member UPP will be described in detail with reference to Table 1.

| Classifica tion | Compara tive Example 1 | Compara tive Example 2 | Compara tive Example 3 | Example 1 | Example 2 | Example 3 | Compara tive Example 4 | Compara tive Example 5 |
|---|---|---|---|---|---|---|---|---|
| Tensile modulus | 70 GPa | 9 GPa | 7 GPa | 5 GPa | 2 GPa | 0.7 GPa | 0.2 GPa | 0.05 GPa |
| Ball drop property | 100% | 88% | 75% | 100% | 120% | 163% | 148% | 175% |
| Pen drop property | 200% | 100% | 100% | 100% | - | 133% | - | 87% |
| Low temperat ure repulsion | 100% | 98% | 97% | 93% | - | 90% | - | 90% |

Table 1 shows experimental data obtained by measuring the properties of various examples for the second film FL2. The modulus, ball drop property, pen drop property, and low temperature repulsion for a single film are evaluated. Comparative Example 1 shows data for an ultra-thin film glass (UTG), Comparative Example 2 shows data for a film having a modulus of 9 Gpa, Comparative Example 3 shows data for a film having a modulus of 7 GPa, Example 1 shows data for a film having a modulus of 5 GPa, Example 2 shows data for a film having a modulus of 2 GPa, Example 3 shows data for a film having a modulus of 0.7 GPa, Comparative Example 4 shows data for a film having a modulus of 0.2 GPa, and Comparative Example 5 shows data for a film having a modulus of 0.05 GPa. The tensile modulus (e.g., e.g., Young's modulus) may be a value at room temperature (25 °C), the ball drop property may be a relative percentage to the ball drop property of the Comparative Example 1, that is, the UTG, under the same conditions, the pen drop property may be a relative percentage to the pen drop property of a PI film under the same conditions, and the low temperature repulsion may be a relative percentage to the ball drop property in Comparative Example 1, that is, the UTG. Referring to Table 1, when the tensile modulus (e.g., e.g., Young's modulus) is greater than 5 GPa, the ball drop property may decrease compared to Comparative Example 1, as in Comparative Examples 2 and 3. As the modulus decreases, the ball drop property generally tends to increase, and it may be seen that the film having a modulus of 5 GPa or less exhibits the ball drop property greater than or equal to that of the UTG.

In some embodiments, the pen drop properties of films are relatively low compared to Comparative Example 1, but it is shown that Example 1 having a modulus of 5 GPa and Example 3 having a modulus of 0.7 GPa have improved pen drop properties of 100% or more. However, it may be seen that when the modulus is extremely low as in Comparative Example 5, the pen drop property becomes weak.

In some embodiments, it may be seen that the films are lower in low temperature repulsion than Comparative Example 1, but the differences are insignificant. However, since the low temperature repulsion tends to decrease as the modulus decreases, and the low temperature repulsion is 90% or less in Comparative Example 5, it may be seen that the low temperature repulsion of 90% or more compared to UTG may be ensured at a modulus of at least about 0.7 GPa or more (e.g., 1 GPa or more, 2 GPa or more).

Therefore, the modulus of one or more (e.g., each) of the films constituting the window member UPP according to an embodiment of the present disclosure is in the range of about 700 MPa (e.g., 2 GPa) to about 5 GPa (e.g., 4 GPa), allowing the window member UPP to have both sufficient repulsive force and impact resistance.

According to the present disclosure, the film FL1 and the film FL3, which respectively form a lower side and an upper side of the window member UPP, are designed to have a modulus higher than the modulus of the film FL2 disposed or arranged in the middle, to keep the modulus of the window member UPP from being increased and improve the impact resistance property of the window member UPP itself. Therefore, the window member UPP having uniform flexibility and impact resistance may be provided.

In some embodiments, the thickness of one or more (e.g., each) of the films constituting the window member UPP may be about 20 µm to about 100 µm, about 40 µm to about 800 µm. When each of the thicknesses T1, T2, and T3 of the first to third films FL1, FL2, and FL3 is less than about 20 µm, it may be difficult to protect the electronic panel EP, and the difficulty of the process may be increased. When each of the thicknesses T1, T2, and T3 of the first to third films FL1, FL2, and FL3 is greater than about 100 µm, peeling during folding or lamination of the first to third films FL1, FL2, and FL3 may easily occur and flexibility may be reduced, leading to a decrease in process reliability. The window member UPP according to the present disclosure may ensure sufficient impact resistance and flexibility by designing one or more (e.g., each) of the films FL1, FL2, and FL3 to have a thickness of about 20 µm to about 100 µm. That is, the window member UPP according to the present disclosure may ensure both rigidity and flexibility. Accordingly, the window member UPP may have flexible property while stably protecting components constituting the electronic apparatus 1000.

The electronic apparatus 1000 according to an embodiment of the present disclosure may have improved rigidity against folding stress and improved impact resistance against external impact by controlling the thicknesses and moduli of the films FL1, FL2, and FL3 constituting the window member UPP.

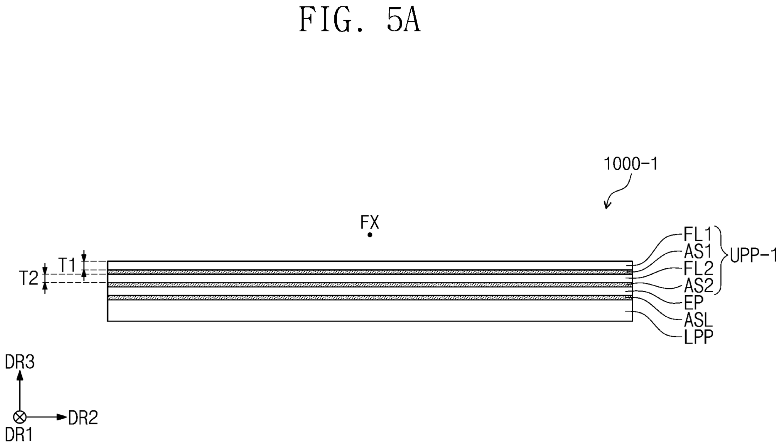

FIGS. 5A to 5C are cross-sectional views schematically illustrating an electronic apparatus according to an embodiment of the present disclosure. FIGS. 5A to 5C illustrate cross-sectional views each corresponding to FIG. 4A. Hereinafter, the present disclosure will be described with reference to FIGS. 5A to 5C.

Referring to FIG. 5A, an electronic apparatus 1000-1 may include a window member UPP-1 composed of two films FL1 and FL2. In some embodiments, the window member UPP-1 may include a first film FL1, a second film FL2, and a plurality of adhesive layers AS1 and AS2. That is, the structure of the window member UPP-1 may correspond to a structure in which the third film FL3 is omitted from the window member UPP illustrated in FIG. 4A.

The first film FL1 may be disposed or arranged on an uppermost side of the window member UPP-1 to define an upper surface of the window member UPP-1. The first film FL1 may be a film spaced farthest from the electronic panel EP among the films constituting the window member UPP-1. The first film FL1 may have a modulus of about 5 GPa or less at room temperature. The thickness T1 of the first film FL1 may be about 20 µm to about 100 µm.

The second film FL2 may be disposed or arranged under the first film FL1. The second film FL2 may be a film disposed or arranged on a lowermost side among the films constituting the window member UPP-1. The second film FL2 may be bonded to a rear surface of the first film FL1 through the first adhesive layer AS1, and may be bonded to the upper surface of the electronic panel EP through the second adhesive layer AS2.

The second film FL2 may have a modulus of about 5 GPa or less at room temperature. The modulus of the second film FL2 may be less than or equal to the modulus of the first film FL1. The modulus of the second film FL2 may be about 700 MPa to about 5 GPa. The thickness T2 of the second film FL2 may be about 20 µm to about 100 µm.

The electronic apparatus 1000-1 according to an embodiment of the present disclosure may have improved rigidity against folding stress and improved impact resistance against external impact by controlling the thicknesses and moduli of the films FL1 and FL2 constituting the window member UPP-1.

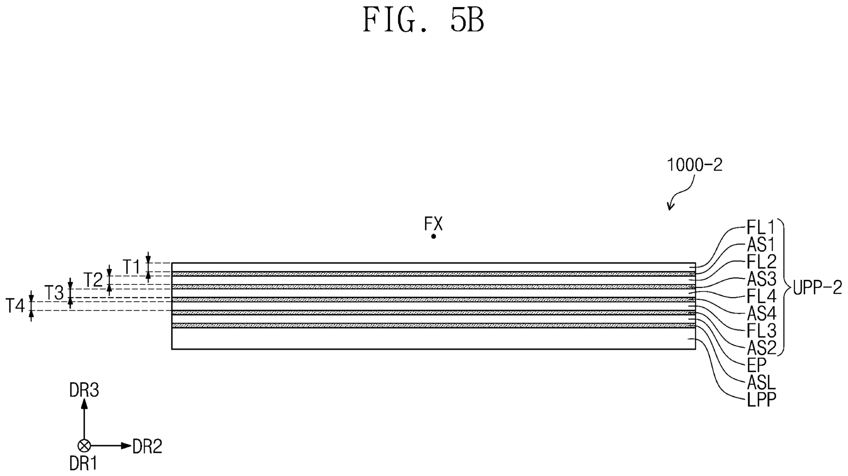

Referring to FIG. 5B, an electronic apparatus 1000-2 may include a window member UPP-2 composed of four films FL1, FL2, FL3, and FL4. In some embodiments, the window member UPP-2 may include a first film FL1, a second film FL2, a third film FL3, a fourth film FL4, and a plurality of adhesive layers AS1, AS2, AS3, and AS4. That is, the structure of the window member UPP-2 may correspond to a structure in which the fourth film FL4 is added to the window member UPP illustrated in FIG. 4A.

The first film FL1 may be disposed or arranged on an uppermost side of the window member UPP-2 to define an upper surface of the window member UPP-2. The first film FL1 may be a film spaced farthest from the electronic panel EP among the films constituting the window member UPP-2. The first film FL1 may have a modulus of about 5 GPa or less at room temperature. The thickness T1 of the first film FL1 may be about 20 µm to about 100 µm.

The second film FL2 may be disposed or arranged under the first film FL1. The second film FL2 may be a film bonded to the first film FL1 through the adhesive layer AS1 among the films constituting the window member UPP-2. The second film FL2 may have a modulus of about 5 GPa or less at room temperature. The modulus of the second film FL2 may be less than or equal to the modulus of the first film FL1. The thickness T2 of the second film FL2 may be about 20 µm to about 100 µm.

The third film FL3 may be a film disposed or arranged on a lowermost side among the films constituting the window member UPP-2 and bonded to the electronic panel EP. The third film FL3 may be attached to the upper surface of the electronic panel EP through the second adhesive layer AS2. The third film FL3 may have a modulus of about 5 GPa or less at room temperature. The modulus of the third film FL3 may be greater than or equal to the modulus of the second film FL2. The thickness T3 of the third film FL3 may be about 20 µm to about 100 µm.

The fourth film FL4 may be disposed or arranged between the second film FL2 and the third film FL3. The third film FL3 and the fourth film FL4 may substantially correspond to the third film FL3 illustrated in FIG. 4A, which is provided in a stacked structure including a plurality of films. The fourth film FL4 may be bonded to a rear surface of the second film FL2 through the third adhesive layer AS3, and may be bonded to the upper surface of the third film FL3 through the additional adhesive layer AS4. The fourth film FL4 may have a modulus of about 5 GPa or less at room temperature. The modulus of the fourth film FL4 may be greater than or equal to the modulus of the second film FL2. A thickness T4 of the fourth film FL4 may be about 20 µm to about 100 µm.

The electronic apparatus 1000-2 according to an embodiment of the present disclosure may have improved rigidity against folding stress and improved impact resistance against external impact by controlling the thicknesses and moduli of the films FL1, FL2, FL3, and FL4 constituting the window member UPP-2.

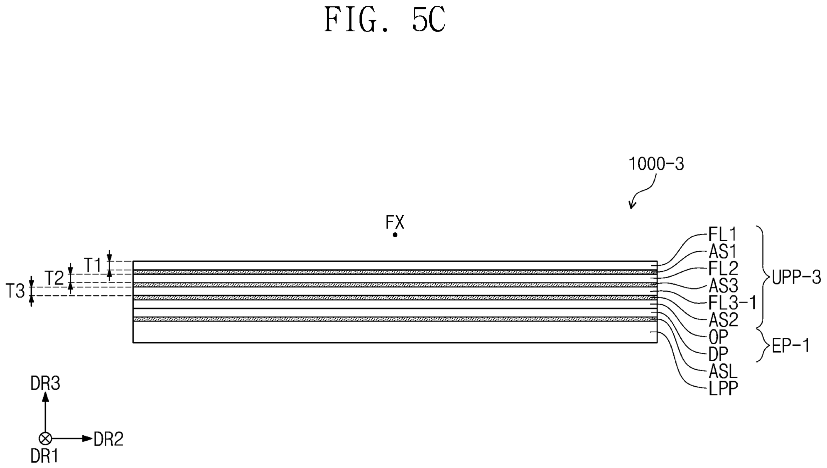

Referring to FIG. 5C, an electronic apparatus 1000-3 may include an electronic panel EP-1 which includes a window member UPP-3 composed of three films FL1, FL2, and FL3-1 and further includes an optical layer OP. In some embodiments, the electronic panel EP-1 may include a display layer DP and an optical layer OP. The optical layer OP may be stacked on the display layer DP. The optical layer OP may be a layer for preventing reflection of external light. Accordingly, the optical layer OP may be a layer which absorbs at least portion of transmitted light. The optical layer OP may correspond to the optical layer OPL of FIG. 3C. For example, the optical layer OP may include a black matrix layer or a color filter layer. The optical layer OP may be directly formed on the display layer DP through a deposition or patterning process.

The window member UPP-3 may include a first film FL1, a second film FL2, a third film FL3, and a plurality of adhesive layers AS1, AS2, and AS3. That is, the structure of the window member UPP-2 may correspond to a structure in which the third film FL3 is changed in shape in the window member UPP illustrated in FIG. 4A.

The first film FL1 may be disposed or arranged on an uppermost side of the window member UPP-3 to define an upper surface of the window member UPP-3. The first film FL1 may be a film spaced farthest from the electronic panel EP-1 among the films constituting the window member UPP-3. The first film FL1 may have a modulus of about 5 GPa or less at room temperature. The thickness T1 of the first film FL1 may be about 20 µm to about 100 µm.

The second film FL2 may be disposed or arranged under the first film FL1. The second film FL2 may be a film bonded to the first film FL1 through an adhesive layer AS1 among the films constituting the window member UPP-2. The second film FL2 may have a modulus of about 5 GPa or less at room temperature. The modulus of the second film FL2 may be less than or equal to the modulus of the first film FL1. The thickness T2 of the second film FL2 may be about 20 µm to about 100 µm.

The third film FL3-1 may be a film disposed or arranged on a lowermost side among the films constituting the window member UPP-3 and bonded to the electronic panel EP. The third film FL3 may be attached to an upper surface of the electronic panel EP through a second adhesive layer AS2. In some embodiments, the third film FL3-1 may be bonded to a rear surface of the second film FL2 through a third adhesive layer AS3. The third film FL3-1 may have a modulus of about 5 GPa or less at room temperature. The modulus of the third film FL3-1 may be greater than or equal to the modulus of the second film FL2. A thickness T3 of the third film FL3-1 may be about 20 µm to about 100 µm.

In some embodiments, one or more (e.g., each) of the first to third films FL1, FL2, and FL3-1 may be a film which does not include a phase retarder PVA. That is, the modulus of one or more (e.g., each) of the first to third films FL1, FL2, and FL3-1 may be a measured value for the components excluding the phase retarder.

The electronic apparatus 1000-3 according to an embodiment of the present disclosure may have improved rigidity against folding stress and improved impact resistance against external impact by controlling the thicknesses and moduli of the films FL1, FL2, and FL3 constituting the window member UPP-3.

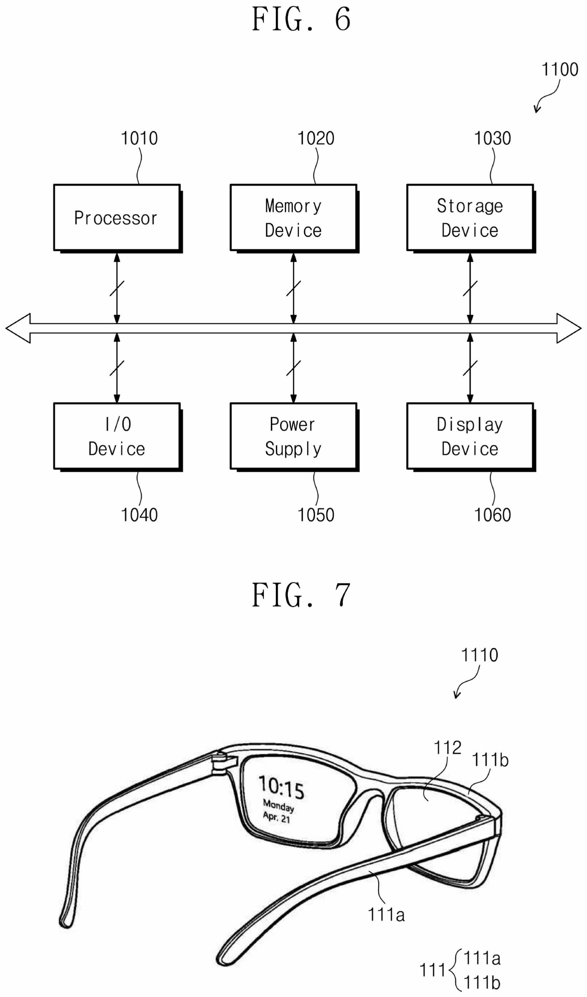

FIG. 6 is a diagram illustrating an electronic apparatus according to an embodiment of the present disclosure.

Referring to FIG. 6, an electronic apparatus 1100 may include a processor 1010, a memory device 1020, a storage device 1030, an input/output device 1040, a power supply 1050, and a display device 1060. The electronic apparatus 1100 may correspond to the electronic apparatus 1000 (see FIG. 3A). That is, the electronic apparatus 1100 may be implemented as various types of devices having a display function, including the display device 1060.

In an embodiment, the electronic apparatus 1100 may include at least one of a smartphone, a tablet personal computer (PC), a mobile phone, a video phone, an e-book reader, a desktop PC, a laptop PC, a netbook computer, a workstation, a server, a personal digital assistant (PDA), a portable multimedia player (PMP), an MP3 player, a mobile medical device, a camera, or a wearable device (for example, smart glasses, a head-mounted-device (HMD), an electronic clothing, an electronic bracelet, an electronic necklace, an electronic accessory, an electronic tattoo, a smart mirror, or a smart watch).

In some embodiments, the electronic apparatus 1100 may be a smart home appliance. The smart home appliance may include at least one of, for example, a television, a digital video disk (DVD) player, an audio system, a refrigerator, an air conditioner, a cleaner, an oven, a microwave, a washing machine, an air purifier, a set-top box, a home automation control panel, a security control panel, a TV box (for example, Samsung HomeSync, Apple TV, or Google TV), a game console (for example, Xbox), an electronic dictionary, an electronic key, a camcorder, or an electronic frame.

In some embodiments, the electronic apparatus 1100 may include at least one of various types of medical devices (for example, a blood glucose meter, a heart rate meter, a blood pressure meter, a thermometer, etc.), a magnetic resistance angiography (MRA), a magnetic resistance imaging (MRI), a computed tomography (CT), a photographer, an ultrasonic device, a navigation device, a global positioning system (GPS) receiver, an event data recorder (EDR), a flight data recorder (FDR), an automobile infotainment device, a ship electronic equipment (for example, a ship navigation device, a gyro compass, etc.), avionics, a security device, a vehicle head unit, an industrial or home robot, an automatic teller's machine (ATM) of a financial institution, point of sales (POS) or Internet of things (for example, light bulbs, various sensors, an electric or gas meter, a sprinkler device, a fire alarm device, a thermostat, a street lamp, a toaster, an exercise equipment, a hot water tank, a heater, a boiler, etc.).

According to some embodiments, the electronic apparatus 1100 may include at least one of a furniture or a portion of a building/structure, an electronic board, an electronic signature receiving device, a projector, or various measurement devices (for example, water, electricity, gas, or a radio wave measurement device). In various embodiments, the electronic apparatus 1100 may be one or a combination of the various devices described above. The electronic apparatus 1100 according to some embodiment may be a flexible electronic apparatus. In some embodiments, the electronic apparatus 1100 according to an embodiment of the present disclosure is not limited to the devices described above, and may include a new electronic apparatus according to technological development.

The processor 1010 may control other components included in the electronic apparatus 1100 and perform various data processing and operations. For example, the processor 1010 may supply data corresponding to a set or predetermined image to the display device 1060. According to embodiments, the processor 1010 may be a microprocessor, a central processing unit, an application processor, or the like.

The memory device 1020 may store data necessary for the operation of the electronic apparatus 1100. For example, the memory device 1020 may include: a nonvolatile memory device such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, or a ferroelectric random access memory (FRAM) device; and/or a volatile memory device such as a dynamic random access memory (DRAM) device, a static random access memory (SRAM) device, or a mobile DRAM device. The memory device 1020 may store instructions that, when executed by the processor 1010, cause the processor to implement one or more of the functionality of the electronic apparatus 1100.

The storage device 1030 may include a solid state drive (SSD), a hard disk drive (HDD), a CD-ROM, and the like. Software used by the electronic apparatus 1100 may be stored in the storage device 1030. For example, an operating system, middleware, an application, and the like may be stored in the storage device 1030.

The input/output device 1040 may receive a command or data to be used in the electronic apparatus 1100 from the outside of the electronic apparatus 1100. To this end, the input/output device 1040 may include a keyboard, a microphone, a mouse, a touch pad, a touch screen, a remote controller, a camera (recognition of motion of a user), and the like. In some embodiments, the input/output device 1040 may output an audio signal to the outside of the electronic apparatus 1100 by using a speaker or the like.

The power supply 1050 may supply power necessary for the operation of the electronic apparatus 1100.

The display device 1060 visually provides information to a user of the electronic apparatus 1100. For example, the display device 1060 may include the display panel described above. In some embodiments, the display device 1060 may include a touch screen to recognize a touch input from the user.

FIGS. 7 to 11 are diagrams illustrating embodiments of an electronic apparatus including a display device according to an embodiment of the present disclosure. As described with reference to FIG. 6, the display device 1060 may be applied to various types of electronic apparatus 1100.

Referring to FIG. 7, the display device 1060 may be applied to smart glass 110. The smart glass 110 may include a frame 111 and a lens unit 112. The smart glass 110 is a wearable electronic apparatus which may be worn on a user's face, and may have a structure in which a portion of the frame 111 is folded or unfolded. For example, the smart glass 110 may be a wearable device for augmented reality (AR).

The frame 111 may include a housing 111B for supporting the lens unit 112 and a leg portion 111A for being worn on a user. The leg portion 111A may be connected to the housing 111B by a hinge to be folded or unfolded.

The frame 111 may include a battery, a touch pad, a microphone, and/or a camera embedded therein. In some embodiments, the frame 111 may include a projector which outputs light, a processor which controls an optical signal, and/or the like.

The lens unit 112 may be an optical member which transmits or reflects light. The lens unit 112 may include glass and/or transparent synthetic resin.

The display device 1060 according to embodiments of the present disclosure may be applied to the lens unit 112. For example, the user may recognize an image displayed by an optical signal transmitted from the projector of the frame 111 through the lens unit 112. For example, the user may recognize information, such as time and date, displayed on the lens unit 112. According to an embodiment, the display device 1060 may be implemented as a transparent display device capable of making an image viewed from both surfaces of the lens unit 112 and making an object recognized beyond the lens unit 112.

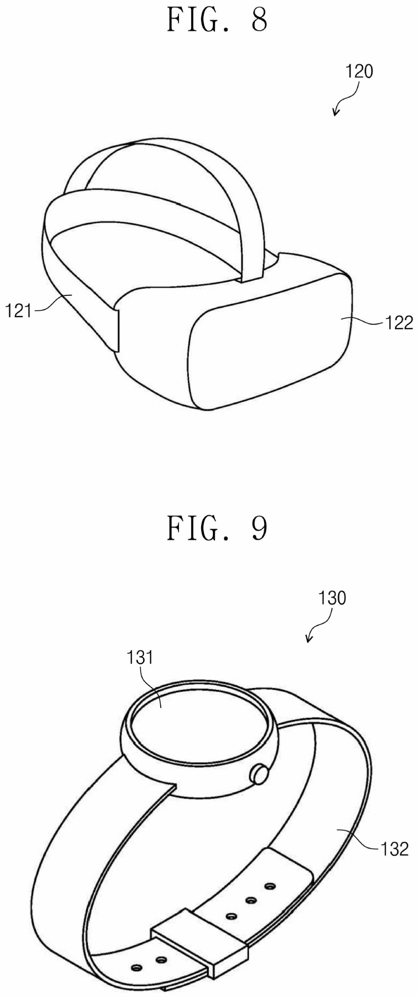

Referring to FIG. 8, the display device 1060 may be applied to a head mounted display (HMD) 120. The head mounted display 120 may include a head mount band 121 and a display accommodation case 122. For example, the head mounted display 120 may be a wearable electronic apparatus which may be worn on a user's head.

The head mount band 121 may be connected to the display accommodation case 122 to fix the display accommodation case 122. The head mount band 121 includes a horizontal band and a vertical band to fix the head mounted display to the user's head, and may be provided such that the horizontal band surrounds a side portion of the user's head and the vertical band surrounds an upper portion of the user's head. However, the present disclosure is not limited thereto, and the head mount band 121 may be implemented in a form of a spectacle frame or a helmet.

The display accommodation case 122 accommodates the display device 1060, and may include at least one lens. At least one lens may provide an image to a user. For example, the display device 1060 may be applied to a left-eye lens and a right-eye lens configured in the display accommodation case 122.

Referring to FIG. 9, the display device 1060 may be applied to a smart watch 130. The smart watch 130 may include a display unit 131 and a strap unit 132. The smart watch 130 is a wearable electronic apparatus, and the strap unit 132 may be mounted on a user's wrist. The display device 1060 according to embodiments of the present disclosure may be applied to the display unit 131. For example, the display unit 131 may provide image data including information such as time and date.

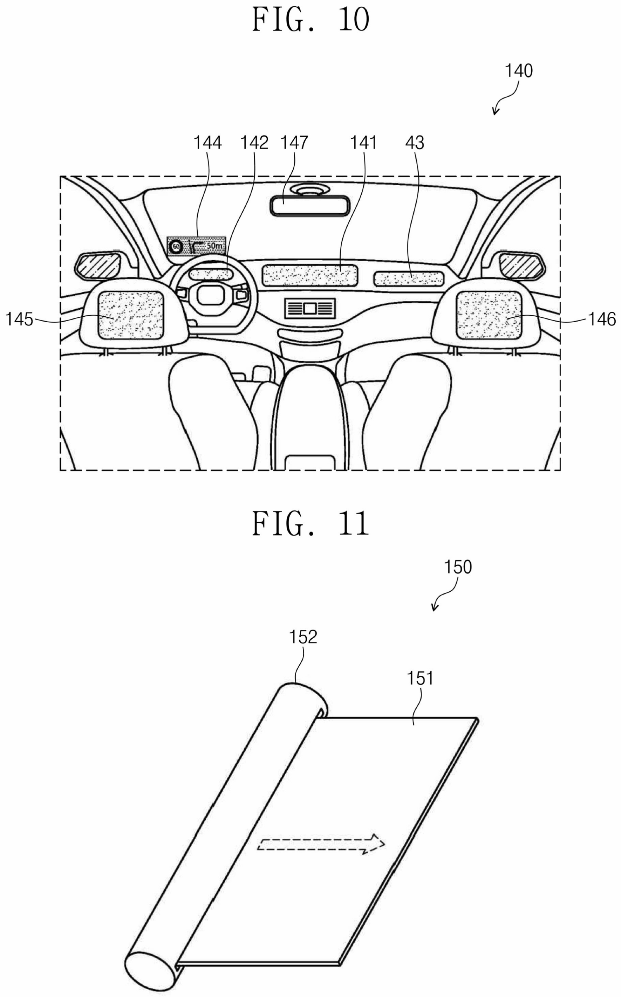

Referring to FIG. 10, the display device 1060 may be applied to a vehicular display 140. For example, the vehicular display 140 may be the electronic apparatus 1100 provided inside and/or outside the vehicle to provide image data.

For example, the display device 1060 may be applied to at least one among an infotainment panel 141, a cluster 142, a co-driver display 143, a head-up display 144, a side mirror display 145, a rear seat display 146, and a rear-view mirror display 147, which are provided in the vehicle.

Referring to FIG. 11, the display device 1060 may be applied to a rollable display device 150. The rollable display device 150 may include a display unit 151 and a housing 152 accommodating the display unit 151. The display unit 151 may correspond to the display panel DP or the electronic panel EP described above (see FIG. 3A). The display unit 151 may be accommodated in the housing 152 in a form wound with a set or predetermined curvature.

When power is applied to the rollable display device 150 or the display function operates, the display unit 151 wound around the roller inside the housing 152 may be slid in a direction indicated by a dotted line due to the rotation of the roller and exposed to the outside of the housing 152. In some embodiments, when power is not applied to the rollable display device 150 or the display function does not operate, the display unit 151 may be slid in a direction opposite to the direction indicated by the dotted line due to the rotation of the roller and wound inside the housing 152.

According to the present disclosure, a foldable stack structure capable of ensuring both flexibility and rigidity may be implemented by designing thicknesses and moduli of a plurality of films constituting the window member of the electronic apparatus within set or predetermined ranges. Accordingly, the electronic apparatus, which has improved impact resistance and relieves stress caused by folding, may be provided.

According to the present disclosure, the first film may be disposed on an uppermost side of the window member (e.g., providing a upper surface of the window member) and/or distant from the panel.

According to the present disclosure, the term "modulus" used herein refers to the Young's modulus. According to the present disclosure, the term "film" refers to a layer. According to the present disclosure, the term "foldable" refers to the capability of being folded (e.g., brought into a folded state) and/or being unfolded (e.g., brought into an unfolded state) by a reversible deformation. For example, each of the electronic panel and the window member are configured to being brought (e.g., by a reversible deformation) into a folded state and being brought (e.g., by a reversible deformation) into unfolded state (e.g., various times).

According to various embodiments, one or more of the first film and the second film has a modulus of about 5 GPa (Gigapascal) or less (e.g., 4 GPa or less) and/or 700 MPa (Megapascal) or more (e.g., 1 GPa or more). Alternatively or additionally, one or more of (if present) the third film and the fourth film has a modulus of about 5 GPa or less (e.g., 4 GPa or less) and/or 700 MPa or more (e.g., 100 GPa or more).

According to various embodiments, one or more of the first film and the second film includes, e.g., is made from, a transparent resin, e.g., having a light transmittance of about 90% or more. Alternatively or additionally, one or more of (if present) the third film and the fourth film includes, e.g., is made from, a transparent resin, e.g., having a light transmittance of about 90% or more.

According to various embodiments, the modulus of the second film is less than the modulus of the first film and/or of the third film (if present). Alternatively or additionally, the modulus of the third film (if present) is greater than or equal to the modulus of the first film and/or the second film.

According to various embodiments, the second film is less than the modulus of the first film and/or of the third film (if present). Alternatively or additionally, the modulus of the third film (if present) is greater than or equal to the modulus of the first film and/or the second film.

In the above, description has been made with reference to embodiments of the present disclosure, but those skilled or of ordinary skill in the art may understand that various modifications and changes may be made to the present disclosure. Therefore, the technical scope of the present disclosure is not to be limited to the contents stated in the detailed description of the specification, but should be determined by the claims.

## Claims

1. An electronic apparatus (1000, 1000-1, 1000-2, 1000-3, 1001, 1100) comprising:
an electronic panel (EP) folded with respect to a folding axis extending along a first direction and including a light-emitting element; and
a window member (UPP) on the electronic panel (EP) and folded with respect to the folding axis,
wherein the window member (UPP) includes:
a first film (FL1) on an uppermost side;
a second film (FL2) between the first film (FL1) and the electronic panel (EP);
a first adhesive layer (AS1) between the first film (FL1) and the second film (FL2) and attached to a rear surface of the first film (FL1); and
a second adhesive layer (AS2) between the electronic panel (EP) and the second film (FL2) and attached to the electronic panel (EP),
wherein, each of the first film (FL1) and the second film (FL2) has a modulus of about 5 GPa or less, and
wherein, a modulus of the second film (FL2) is greater than about 700 MPa.

2. The electronic apparatus (1000, 1000-1, 1000-2, 1000-3, 1001, 1100) of claim 1, wherein the modulus of the second film (FL2) is smaller than the modulus of the first film (FL1).

3. The electronic apparatus (1000, 1000-1, 1000-2, 1000-3, 1001, 1100) of claim 1 or 2, wherein each of the first film (FL1) and the second film (FL2) has a thickness in a range from approximately 20 µm to approximately 100 µm.

4. The electronic apparatus (1000, 1000-1, 1000-2, 1000-3, 1001, 1100) of one of claims 1 of the 3, further comprising:
a third film (FL3) between the electronic panel (EP) and the second film (FL2); and
a third adhesive layer (AS3) between the third film (FL3) and the second film (FL2) and configured to bond the second film (FL2) and the third film (FL3).

5. The electronic apparatus (1000, 1000-1, 1000-2, 1000-3, 1001, 1100) of claim 4, wherein a modulus of the third film (FL3) is:
about 5 GPa or less; and/or
greater than or equal to the modulus of the first film (FL1).

6. The electronic apparatus (1000, 1000-1, 1000-2, 1000-3, 1001, 1100) of claim 4 or 5, wherein the modulus of the second film (FL2) is smaller than the modulus of each of the first film (FL1) and the third film (FL3).

7. The electronic apparatus (1000, 1000-1, 1000-2, 1000-3, 1001, 1100) of one of claims 4 to 6, wherein the first to third films (FL3) each have a thickness of greater than about 20 µm and smaller than about 100 µm.

8. The electronic apparatus (1000, 1000-1, 1000-2, 1000-3, 1001, 1100) of one of claims 4 to 7, wherein a thickness of the third film (FL3) is greater than or equal to a thickness of each of the first film (FL1) and the second film (FL2).

9. The electronic apparatus (1000, 1000-1, 1000-2, 1000-3, 1001, 1100) of claim 8, wherein the thickness of the second film (FL2) is less than or equal to the thickness of each of the first film (FL1) and the third film (FL3).

10. The electronic apparatus (1000, 1000-1, 1000-2, 1000-3, 1001, 1100) of one of claims 4 to 9, further comprising a fourth film between the third film (FL3) and the second film (FL2), wherein a modulus of the fourth film is about 5 GPa or less.

11. The electronic apparatus (1000, 1000-1, 1000-2, 1000-3, 1001, 1100) of one of claims 1 to 10, wherein each of the first film (FL1) and the second film (FL2) has a light transmittance of about 90% or more.

12. The electronic apparatus (1000, 1000-1, 1000-2, 1000-3, 1001, 1100) of one of claims 1 to 11, wherein each of the first film (FL1) and the second film (FL2) comprises a resin.

13. The electronic apparatus (1000, 1000-1, 1000-2, 1000-3, 1001, 1100) of one of claims 1 to 10, wherein the electronic panel (EP) comprises a color filter or black matrix.

14. The electronic apparatus (1000, 1000-1, 1000-2, 1000-3, 1001, 1100) of one of claims 1 to 13, wherein the window member (UPP) is folded in a direction surrounding the folding axis.

15. The electronic apparatus (1000, 1000-1, 1000-2, 1000-3, 1001, 1100) of one of claims 1 to 13, further comprising:
a housing (111B, 152, EDC1, EDC2) disposed under the electronic panel (EP) and configured to provide an accommodation space for accommodating the electronic panel (EP),
wherein the window member (UPP) includes
a third film (FL3) on a lowermost side and bonded to the electronic panel (EP) via an adhesive layer;
wherein, each of the first to third films (FL3) has a modulus of about 5 GPa or less;
wherein, preferably, the thickness of the first film (FL1) is greater than or equal to the thickness of each of the second film (FL2) and the third film (FL3).
